# EUROPEAN PATENT APPLICATION

(11) **EP 2 503 536 A1**
(43) Date of publication of application: **26.09.2012**
(21) Application number: 11006463.1
(22) Date of filing: 05.08.2011
(51) Int. Cl.: G09G 3/32

(54) **Active matrix electroluminescent display**

(30) Priority: 23.03.2011 US 70262
(71) Applicant: AU Optronics Corporation, Hsin-Chu (TW)
(72) Inventor: Hsuan-Ming, Tsai, Hsin-Chu Chinese Taipei (TW); Chun-Yen, Liu, Hsin-Chu Chinese Taipei (TW); Chia-Yuan, Yeh, Hsin-Chu Chinese Taipei (TW)
(74) Representative: BiiP cvba

(57) **Abstract**

The present invention, in one aspect, relates to an active matrix electroluminescent display device. In one embodiment, the active matrix electroluminescent display device includes an emission layer and a circuit layer. The emission layer includes a plurality of regularly-spaced emission pixels disposed in a row. The circuit layer is disposed under the emission layer and includes a plurality of pixel circuits. Each pixel circuit is electrically coupled to a respective emission pixel for controlling the current through the respective emission pixel in response to an applied data signal. The plurality of pixel circuits is spatially arranged into a plurality of groups with each group including one or more adjacent pixel circuits. Any two neighboring groups of adjacent pixel circuits are separated by a space therebetween. The circuit layer further includes a plurality of buffer circuits connected to each other in series. Each buffer circuit is configured to drive a respective group of adjacent pixel circuits in response to a scan signal. At least one buffer circuit is positioned in a respective space between two neighboring groups of adjacent pixel circuits.

## Description

### FIELD OF THE INVENTION

The present invention relates generally to an active matrix electroluminescent display, and more particularly, to an active matrix organic light emitting diode (AMOLED) display with a slim border.

### BACKGROUND OF THE INVENTION

Display devices employing electroluminescent display elements, such as organic light emitting diodes (OLEDs), have become a popular choice among flat panel displays. OLED displays are used as television screens, computer monitors, portable electronic systems such as mobile phones and personal digital assistants (PDAs). An OLED is a light emitting diode (LED) in which the emissive electroluminescent layer is a film of organic compounds which emit light in response to an electric current. This layer of organic semiconductor material is situated between two electrodes. Generally, at least one of these electrodes is transparent. An OLED display functions without a backlight. Thus, it can display deep black levels and can also he thinner and lighter than other flat panel displays such liquid crystal displays (LCDs). OLED displays can use either passive-matrix (PMOLED) or active-matrix (AMOLED) addressing schemes. AMOLED is more suitable for higher resolution and larger size displays.

An AMOLED display normally comprises a circuit layer formed on a substrate such as glass and an emission layer formed on the circuit layer. The emission layer comprises a plurality of regularly-spaced emission pixels positioned in a display area in a form of a matrix with a plurality of rows and a plurality of columns. For color displays, each emission pixel may further comprise a plurality of color pads, such as red, green, and blue (RGB) color pads. The circuit layer comprises a plurality of pixel circuits. Each pixel circuit is electrically coupled to a respective emission pixel for controlling the current through the respective emission pixel in response to an applied data signal.

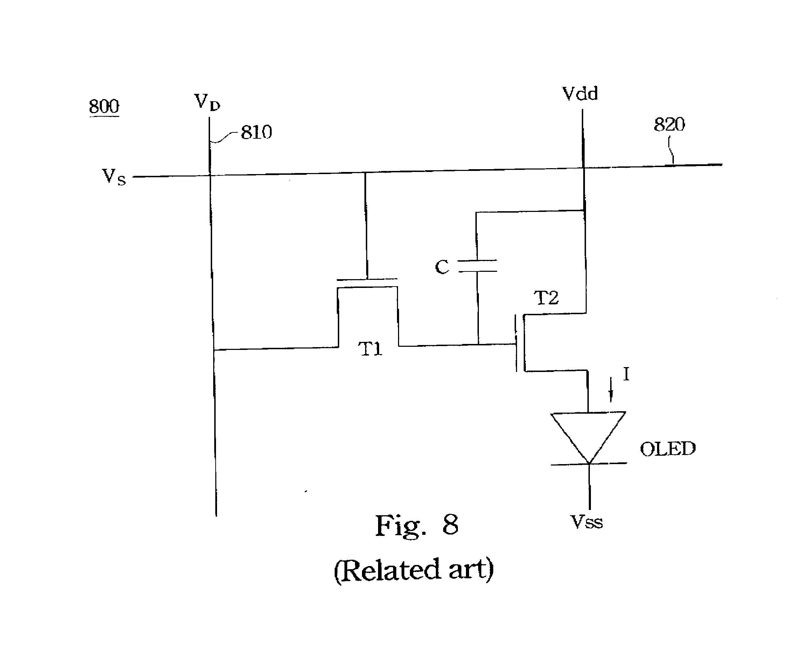

Fig. 8 shows a schematic circuit diagram of an exemplary pixel circuit 800 of an AMOLED display. The pixel circuit 800 includes an OLED, two transistors T1 and T2, and a storage capacitor C. A source electrode of the transistor T1 is connected to a data line 810 for receiving a data signal V_{O}. A gate electrode of the transistor T1 is connected to a scan line 820 for receiving a scan signal V_{S}. A source electrode of the transistor T2 is connected to an anode of the OLED. A gate electrode of the transistor T2 is connected to a drain electrode of the transistor T1. A drain electrode of the transistor T2 is provided with a potential Vdd. A cathode of the OLED is provided with a potential V_{SS}. One end of the storage capacitor C is connected to the gate electrode of the transistor T2; and the other end of the storage capacitor C is connected to the drain electrode of the transistor T2. To generate a steady current 1 passing through the OLED to maintain brightness, a scan voltage V_{S} is applied through the scan line 820 to turn on the transistor T1. This enables a data signal voltage V_{D} on the data line 810 to be applied to the gate electrode of the transistor T2. The difference between the gate to source voltage and the threshold voltage of the transistor T2 determines the value of the current I passing through the OLED and thus the brightness of the OLED. The transistors T1 and T2 are normally thin film transistors (TFTs) fabricated on a substrate using deposition techniques.

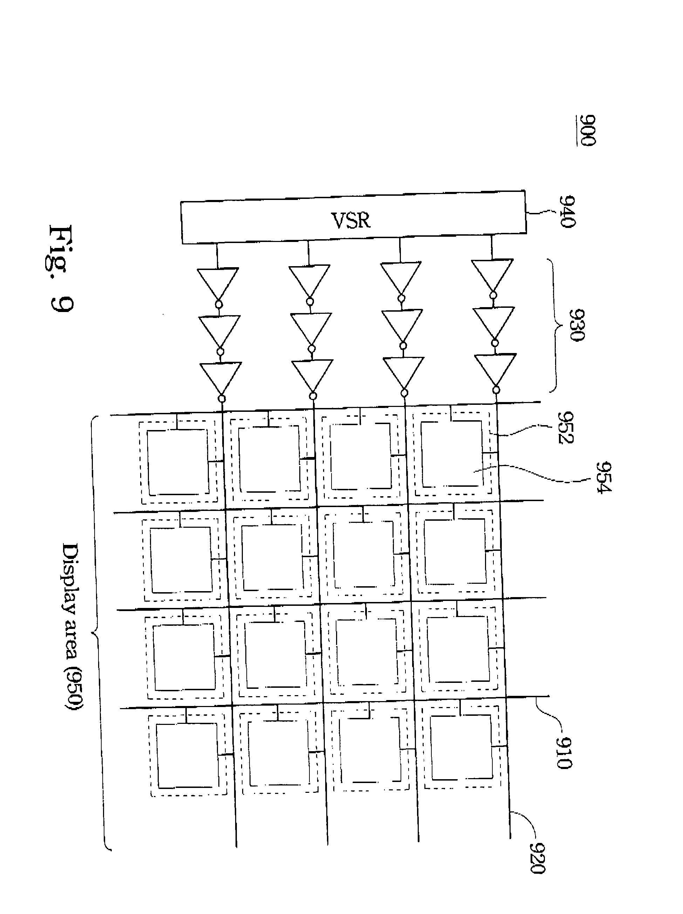

Fig. 9 shows schematically a conventional AMOLED display device 900. The AMOLED display device 900 includes a plurality of regularly-spaced emission pixels 952 (each represented by a dashed square) positioned in a display area 950 and a plurality of pixel circuits 954 (each represented by a solid square). Each pixel circuit 954 is positioned directly below and electrically coupled a respective emission pixel 952 for controlling the current through the respective emission pixel 952 in response to an applied data signal. The pixel circuits 954 in each column arc coupled to a respective data line 910. The pixel circuits 954 in each row are coupled to a respective scan line 920. The AMOLED display device 900 further includes a vertical shift registers (VSR) 940 and a plurality of buffer circuits 930. The VSR 940 comprises a plurality of stages. Each VSR stage is configured to output a scan signal to a respective buffer circuit 930 to drive a respective row of pixel circuits 954. The plurality of VSR stages are connected to each other in series such that successive rows of pixel circuits are sequentially driven in a row by row fashion in response to a clock signal.

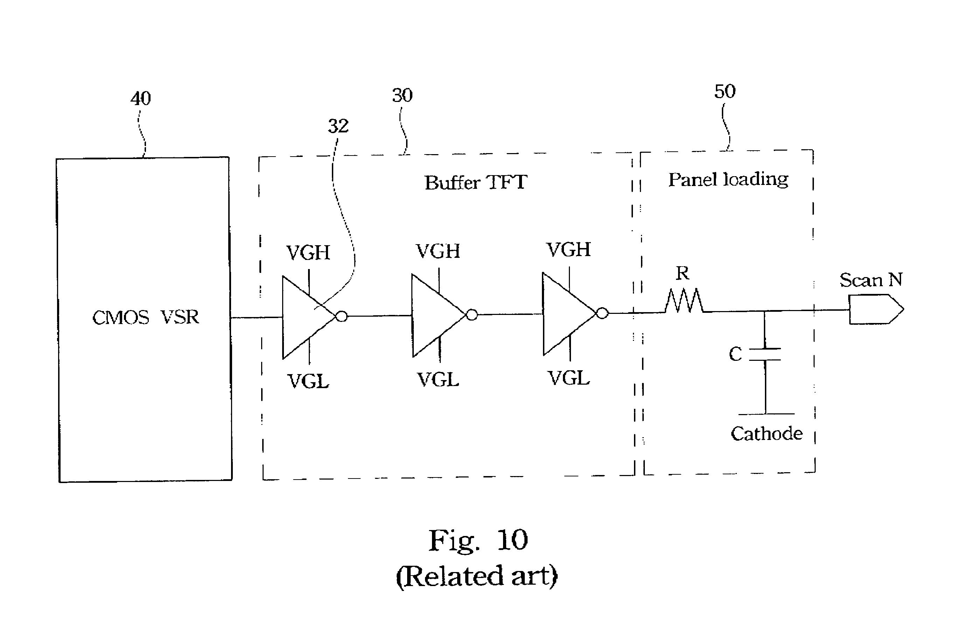

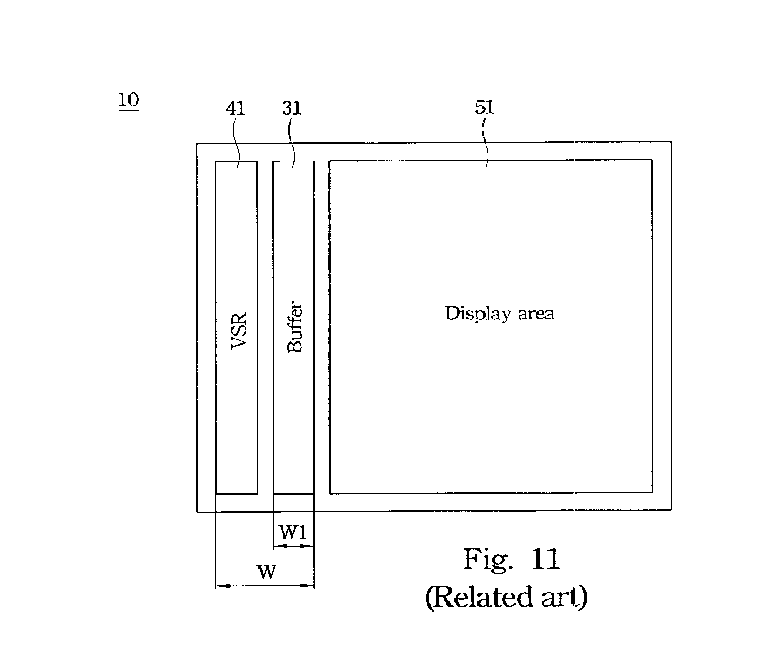

Fig. 10 is an equivalent circuit diagram for one pixel row of the AMOLED display device 900 shown in Fig. 9. A complimentary metal oxide semiconductor (CMOS) VSR stage 40 outputs a scan signal to a buffer circuit 30, which drives a panel loading 50 of a corresponding row of pixels. The panel loading 50 is represented by an equivalent RC circuit. The buffer circuit 30 performs wave shaping to the scan signal so that it can sufficiently cope with the panel loading 50. The buffer circuit 30 may comprise several logic inverters 32 connected to each other in series. Each logic inverter 32 comprises a TFT having a channel width along the row direction. The driving ability of a buffer circuit is determined largely by the channel width-to-length-ratio (W/L) of the TFT. It is preferable that the channel width of the TFT in one logic inverter is greater than the channel width of the TFT in a previous logic inverter in the series. With this construction, the driving ability of the buffer circuit is enhanced. In order for the buffer circuit 30 to have sufficient driving ability to drive the panel loading 50 of an entire row of pixels, the width of the buffer circuit 30 may be quite wide. Fig. 11 shows schematically the layout of a conventional AMOLED display device 10. The AMOLED display device 10 includes a display area 51 where the emission pixels and pixel circuits are disposed. A VSR 41 and buffer circuits 31 may be disposed at the left or right peripheral edge of the display area. Because the width W1 of the buffer circuits 31 needs to be sufficiently wide as described above, the total border width W of the display device 10 may be quite wide.

Therefore, a heretofore unaddressed need exists in the art to address the aforementioned deficiencies and inadequacies.

### SUMMARY OF THE INVENTION

The present invention, in one aspect, relates to an active matrix electroluminescent display device. In one embodiment, the active matrix electroluminescent display device includes an emission layer and a circuit layer. The emission layer includes a plurality of regularly-spaced emission pixels disposed in a row. The circuit layer is disposed under the emission layer and includes a plurality of pixel circuits. Each pixel circuit is electrically coupled to a respective emission pixel for controlling the current through the respective emission pixel in response to an applied data signal. The plurality of pixel circuits is spatially arranged into a plurality of groups with each group including one or more adjacent pixel circuits. Any two neighboring groups of adjacent pixel circuits are separated by a space therebetween. The circuit layer further includes a plurality of buffer circuits connected to each other in series. Each buffer circuit is configured to drive a respective group of adjacent pixel circuits in response to a scan signal. At least one buffer circuit is positioned in a respective space between two neighboring groups of adjacent pixel circuits.

In one embodiment, the number of pixel circuits in each group is the same for all groups.

In another embodiment, each buffer circuit includes one or more logic inverters. Each logic inverter comprises a thin film transistor (TFT) having a channel width along the row direction.

In yet another embodiment, the one or more logic inverters in each buffer circuit includes two ore more logic inverters connected to each other in series, wherein a TFT of any one but the first logic inverter has a channel width that is greater than a channel width of a TFT of a previous logic inverter.

In a further embodiment, each pixel circuit comprises a TFT.

In another aspect, the present invention relates to an active matrix electroluminescent display device. In one embodiment, the active matrix electroluminescent display device includes an emission layer and a circuit layer. The emission layer includes a plurality of regularly-spaced emission pixels positioned in a display area in a form of a matrix with a plurality of rows and a plurality of columns. The circuit layer is disposed under the emission layer and includes a plurality of pixel circuits. Each pixel circuit is electrically coupled to a respective emission pixel for controlling the current through the respective emission pixel in response to an applied data signal. The plurality of pixel circuits is spatially arranged in a plurality of zones. Each zone includes one or more columns of pixel circuits and has an area with a width in the row direction that is narrower than a width of an area occupied by corresponding one or more columns of emission pixels in the emission layer such that any two neighboring zones are separated by a space therebetween. The circuit layer further includes a plurality of buffer circuitries. Each buffer circuitry is electrically coupled to a respective row of pixel circuits and includes a plurality of buffer circuits connected to each other in series. Each buffer circuit is configured to drive one or more adjacent pixel circuits in a respective zone in the respective row in response to a scan signal. At least one buffer circuit is positioned in a respective space between two neighboring zones.

In one embodiment, the active matrix electroluminescent display device further includes a shift register. The shift register includes a plurality of stages. Each stage is configured to output a scan signal to a respective buffer circuitry in response to a clock signal. The plurality of stages of the shift register is connected to each other in series so that successive rows of pixel circuits are sequentially driven in a row-by-row fashion.

In one embodiment, the shift register is disposed at a peripheral edge of the display area in the column direction.

In one embodiment, the plurality of stages of the shift register is disposed at two opposite peripheral edges of the display area in the column direction.

In another embodiment, each stage of the shift register comprises a thin film complementary metal oxide semiconductor (CMOS) transistor.

In yet another embodiment, each buffer circuit in each buffer circuitry comprises at least one TFT having a channel width along the row direction.

In a further embodiment, each pixel circuit comprises at least one TFT.

In yet another aspect, the present invention relates to a method of driving an active matrix electroluminescent display device. The active matrix electroluminescent display device includes an emission layer and a circuit layer. The emission layer includes a plurality of regularly-spaced emission pixels disposed in a display area in a form of a matrix with a plurality of rows and a plurality of columns. The circuit layer is disposed under the emission layer and includes a plurality of pixel circuits. Each pixel circuit is electrically coupled to a respective emission pixel for controlling the current through the respective emission pixel in response to an applied data signal. The plurality of pixel circuits in each row is arranged into a plurality of groups with each group including one or more adjacent pixel circuits. The method includes the step of providing a clock signal to a shift register. The shift register includes a plurality of stages. Each stage corresponds to a respective row of pixel circuits and is configured to output a scan signal to a respective buffer circuitry in response to the clock signal. The respective buffer circuitry includes a plurality of buffer circuits connected to each other in series. Each buffer circuit is configured to drive a respective group of adjacent pixel circuits in the respective row. The plurality of stages of the shift register is connected to each other in series such that successive rows of pixel circuits are sequentially driven in a row-by-row fashion.

In one embodiment, at least one buffer circuit in each buffer circuitry is disposed in a space between two neighboring groups of adjacent pixel circuits in the respective row.

In another embodiment, the shift register is disposed at a peripheral edge of the display area in the column direction.

In a further embodiment, the plurality of stages of the shift register is disposed at two opposite peripheral edges of the display area in the column direction.

These and other aspects of the present invention will become apparent from the following description of the preferred embodiment taken in conjunction with the following drawings, although variations and modifications therein may be affected without departing from the spirit and scope of the novel concepts of the disclosure.

### BRIEF DESCRIPTION OF THE DRAWINGS

The accompanying drawings illustrate one or more embodiments of the invention and, together with the written description, serve to explain the principles of the invention. Wherever possible, the same reference numbers are used throughout the drawings to refer to the same or like elements of an embodiment, and wherein:
Fig. 1 shows schematically an electroluminescent display device according to one embodiment of the present invention;
Fig. 2 shows an equivalent circuit diagram for one pixel row of the electroluminescent display device shown in Fig. 1;
Fig. 3 shows schematically a layout of an electroluminescent display device according to one embodiment of the present invention;
Fig. 4 illustrates the relationship between the emission layer and the circuit layer for the electroluminescent display device shown in Fig. 3;
Fig. 5 shows schematically a layout of buffer circuits in the electroluminescent display device shown in Fig. 3;
Fig. 6 shows schematically a layout of emission pixels, pixel circuits, and buffer circuits of an electroluminescent display device according to one embodiment of the present invention;
Fig. 7 shows schematically a partial cross sectional view of an electroluminescent display device according to one embodiment of the present invention;
Fig. 8 shows a schematic circuit diagram of an exemplary pixel circuit in an electroluminescent display device;
Fig. 9 shows schematically a conventional electroluminescent display device;
Fig. 10 shows an equivalent circuit diagram for one pixel row of the electroluminescent display device shown in Fig. 9; and
Fig. 11 shows schematically the layout of a conventional electroluminescent device.

### DETAILED DESCRIPTION OF THE INVENTION

The present invention is more particularly described in the following examples that are intended as illustrative only since numerous moditications and variations therein will be apparent to those skilled in the art. Various embodiments of the invention are now described in detail. Referring to the drawings, like numbers indicate like components throughout the views. As used in the description herein and throughout the claims that follow, the meaning of "a", "an", and "the" includes plural reference unless the context clearly dictates otherwise. Also, as used in the description herein and throughout the claims that follow, the meaning of "in" includes "in" and "on" unless the context clearly dictates otherwise.

The terms used in this specification generally have their ordinary meanings in the art, within the context of the invention, and in the specific context where each term is used. Certain terms that are used to describe the invention are discussed below, or elsewhere in the specification, to provide additional guidance to the practitioner regarding the description of the invention. The use of examples anywhere in this specification, including examples of any terms discussed herein, is illustrative only, and in no way limits the scope and meaning of the invention or of any exemplified term. Likewise, the invention is not limited to various embodiments given in this specification.

As used herein, "around", "about" or "approximately" shall generally mean within 20 percent, preferably within 10 percent and more preferably within 5 percent of a given value or range. Numerical quantities given herein are approximate, meaning that the term "around", "about" or "approximately" can be inferred if not expressly stated.

As used herein, the terms "comprising," "including," "having," "containing," "involving," and the like arc to be understood to be open-ended, i.e., to mean including but not limited to.

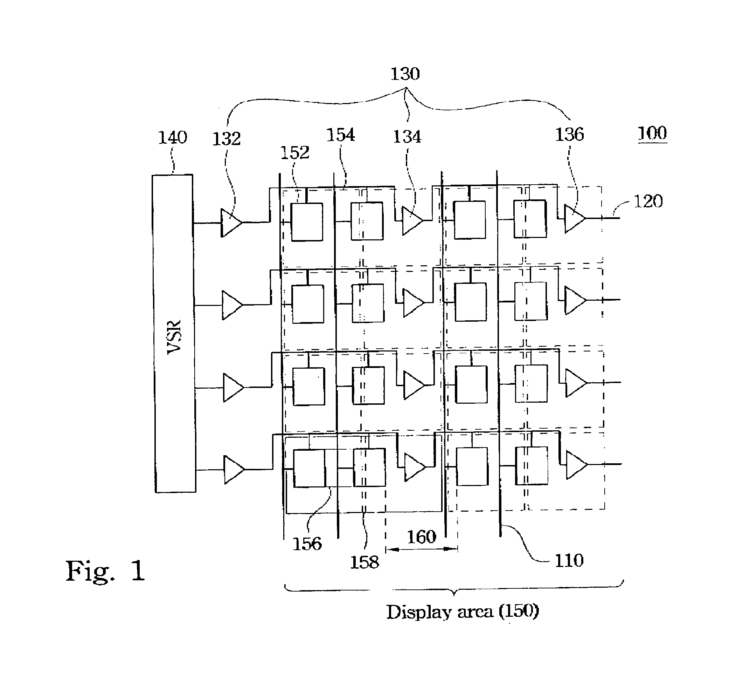

The description will be made as to the embodiments of the present invention in conjunction with the accompanying drawings in Figs. 1-7. In accordance with the purposes of this invention, as embodied and broadly described herein, this invention, in one aspect, relates to an electroluminescent display device, more particularly to an AMOLED display device with a slim border.

Fig. 1 shows schematically an AMOLED display device 100 according to one embodiment of the present invention. The AMOLED display device 100 comprises an emission layer and a circuit layer. The emission layer comprises a plurality of regularly spaced emission pixels 154 (each represented by a dashed square) disposed in a display area 150 in a form of a matrix with a plurality of rows and a plurality of columns. The circuit layer is disposed under the emission layer and comprises a plurality of pixel circuits 152 (each represented by a solid rectangle), those skill in the art known that the circuit layer disposed behind emission layer for prevent reducing aperture ratio. Each pixel circuit is electrically coupled to a respective emission pixel 154 for controlling the current through the respective emission pixel 154 in response to an applied data signal. The pixel circuits in each column are coupled to a respective data line 110. The plurality of pixel circuits 152 in each row is spatially arranged into a plurality of groups with each group including one or more adjacent pixel circuits 152. In this illustrative example, each group includes two adjacent pixel circuits 152. Each group of adjacent pixel circuits 152 occupies an area 156 (dark shaded area) having a width in the row direction that is narrower than the area 158 (light shaded area) occupied by the corresponding emission pixels, so that any two neighboring groups of adjacent pixel circuits 152 are separated by a space 160 therebetween.

The AMOLED display device 100 further includes a plurality of buffer circuitries 130. Each buffer circuitry 130 is configured to receive a scan signal from a shift register 140 and is electrically coupled to a respective row of pixel circuits 152 through a scan line 120. Each buffer circuitry 130 includes a plurality of buffer circuits 132/134/136 connected to each other in series. Each buffer circuit 132/134/136 is configured to drive a respective group of adjacent pixel circuits 152 in the respective row in response to a scan signal. Since each buffer circuit 132/134/136 only drives one group of adjacent pixel circuits as compared of an entire row of pixel circuits in a conventional AMOLED display device, each buffer circuit 132/134/136 may be made with a relatively narrow channel width in the row direction and may be positioned in a spaces 160 between two neighboring groups of adjacent pixel circuits 152 in the display area 150. Accordingly, the AMOLED display device 100 can be made with a relatively slim border compared to a conventional AMOLED display device.

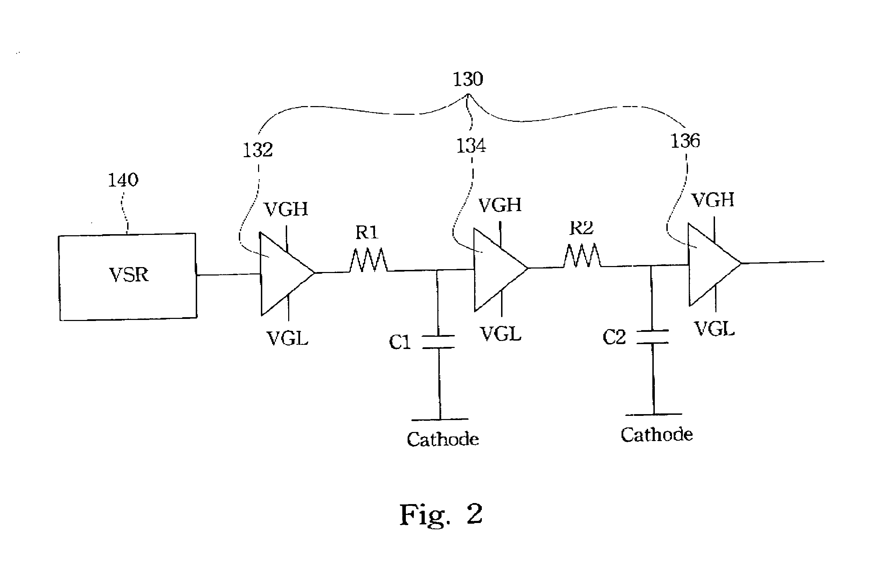

Fig. 2 shows an equivalent circuit diagram for one pixel row of the AMOLED display device 100 shown in Fig. 1. In this diagram, R1 and C1 represent the equivalent circuit loading for the first group of pixel circuits, and R2 and C2 represent the equivalent circuit loading for the second group of pixel circuits, etc. In operation, the shift register 140 outputs a scan signal to the buffer circuitry 130. The first buffer circuit 132 of the buffer circuitry 130 drives the circuit loading of R1 and C1, and the second buffer circuit 134 of the buffer circuitry 130 drives the circuit loading of R2 and C2, etc. In one embodiment, each buffer circuit 132/134/136 comprises one or more logic inverters. Each logic inverter comprises a TFT.

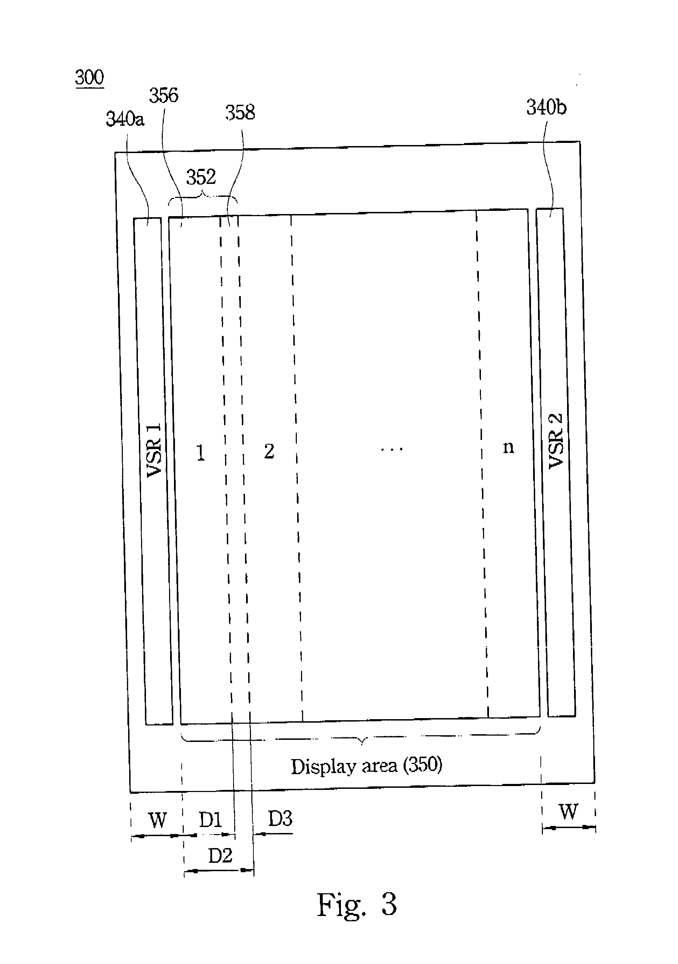

Fig. 3 shows schematically a layout of an AMOLED display device 300 according to one embodiment of the present invention. The AMOLED display device 300 includes a display area 350. In a circuit layer of the display device 300, the display area 350 is divided into n vertical zones 356, where n is an integer greater than or equal to 2. Each zone 356 has an area with a width of D1 in the row direction and includes one or more columns of pixel circuits. Any two neighboring zones 356 are separated by a space 358 of width D3 in the row direction, in which a column of buffer circuits is disposed. In an emission layer of the display device 300, a corresponding zone 352 has an area with a width of D2 in the row direction. Neighboring zones 352 are arranged next to each other without any space therebetween. A VSR 340a and 340b is disposed at the left and right peripheral edges of the display area 350 and is coupled to the buffer circuits disposed in the spaces 358 between neighboring zones 356 in the display area 350. The AMOLED display device 300 can be made with a relatively narrow border with a width W.

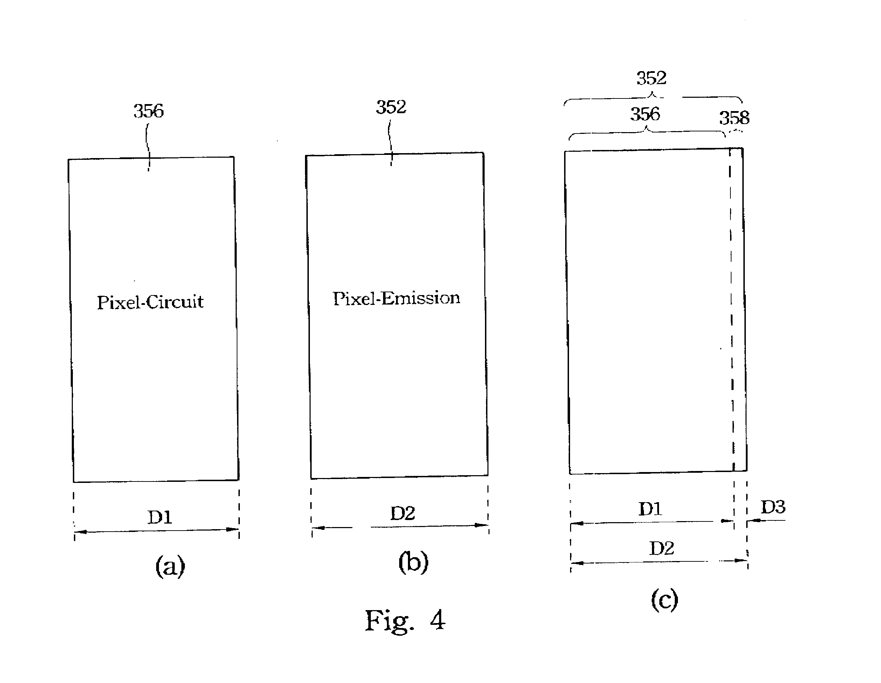

Fig. 4 illustrates the relationship between the emission layer and the circuit layer for the AMOLED display device 300. Figs. 4a and 4b show a zone 356 in the circuit layer and a corresponding zone 352 in the emission layer, respectively. The zone 356 in the circuit layer and the zone 352 in the emission layer have a width of D1 and D2 respectively, D1 being less than D2. In Fig. 4c, the zone 352 in the emission layer is overlaid on top of the zone 356 in the circuit layer as is the case in an AMOLED display device. While neighboring zones 352 in the emission layer are arranged right against each other without any space therebetween, neighboring zones 356 in the circuit layer are separated by a space 358 with a width of D3 as indicated in Fig. 4c.

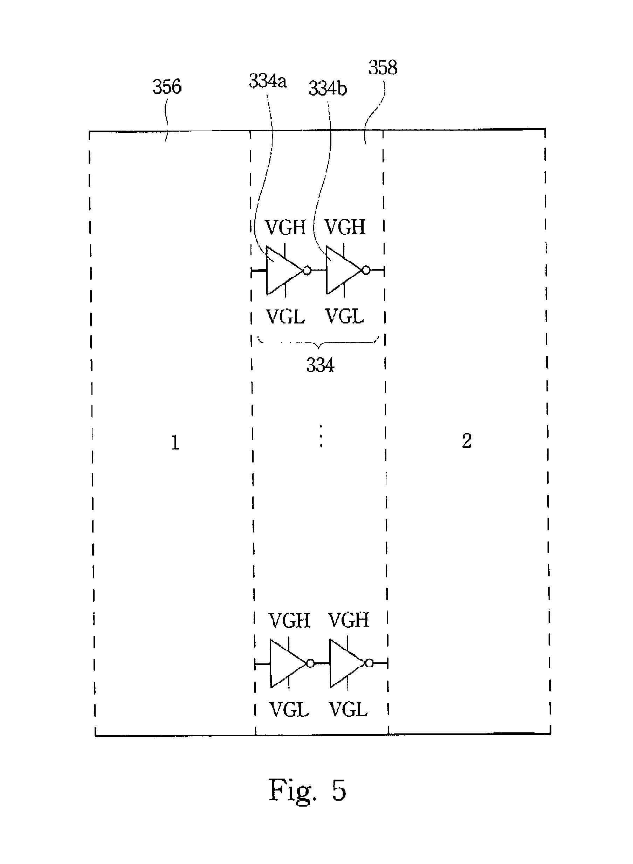

Fig. 5 shows schematically a layout of buffer circuits 334 in a space 358 between two neighboring zones 356. In each row, there is a buffer circuit 334 for driving a group of adjacent pixel circuits in the zone to the right of the space 358. In this illustrative example, each buffer circuit 334 comprises two logic inverters 334a and 334b connected to each other in series. In other embodiments, each buffer circuit 334 may comprise more or fewer number of logic inverters connected to each other in series. Each logic inverter comprises a TFT having a channel width along the row direction. In one embodiment, any one but the first logic inverter has a channel width that is greater than a channel width of a TFT of a previous logic inverter.

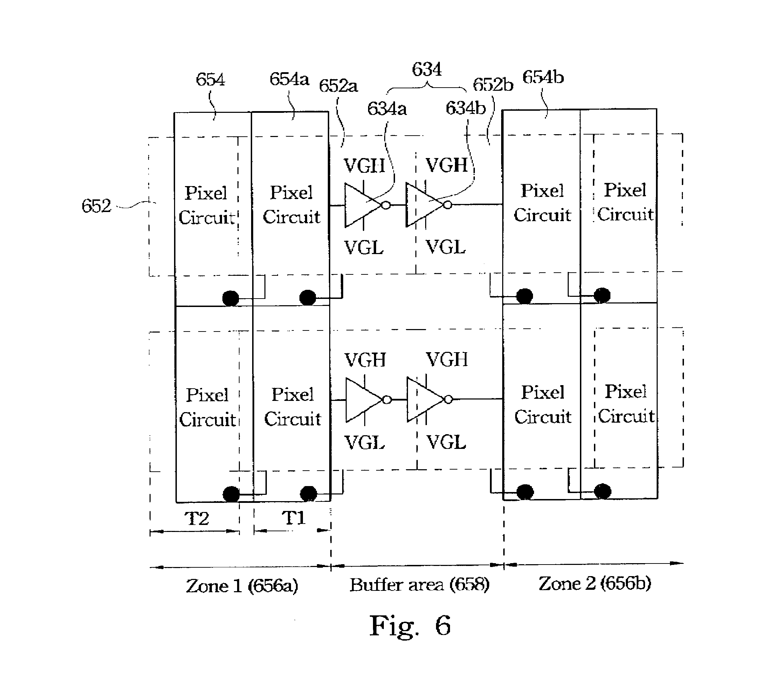

Fig. 6 shows schematically a layout of emission pixels, pixel circuits, and buffer circuits in a region in the vicinity of a space 658 between two neighboring zones 656a and 656b, according to one embodiment of the present invention. Emission pixels 652 (represented by dashed rectangles) in each row are arranged as a regular array. Pixel circuits 654 (represented by solid rectangles) in each row are arranged into groups with a space 658 between two neighboring groups. Each pixel circuit 654 occupies an area with a width T1 that is narrower than a width T2 of the area occupied by each emission pixel 652. Some emission pixels 652 are located in the space 658 between neighboring groups of pixel circuits 654. In this illustrative example, in each row, two emission pixels 652a and 652b are located in the space 658. One of those two emission pixels 652a is coupled to the pixel circuit 654a in the first zone 656a; the other one of the two emission pixels 652b is coupled to the pixel circuit 654b in the second zone 656b. In each row, a buffer circuit 634 is positioned in the space 658 between the first zone 656a and the second zone 656b and is configured to drive the pixel circuits in the second zone 656b in the corresponding row in response to a scan signal. In this embodiment, each buffer circuit 634 comprises two logic inverters 634a and 634b.

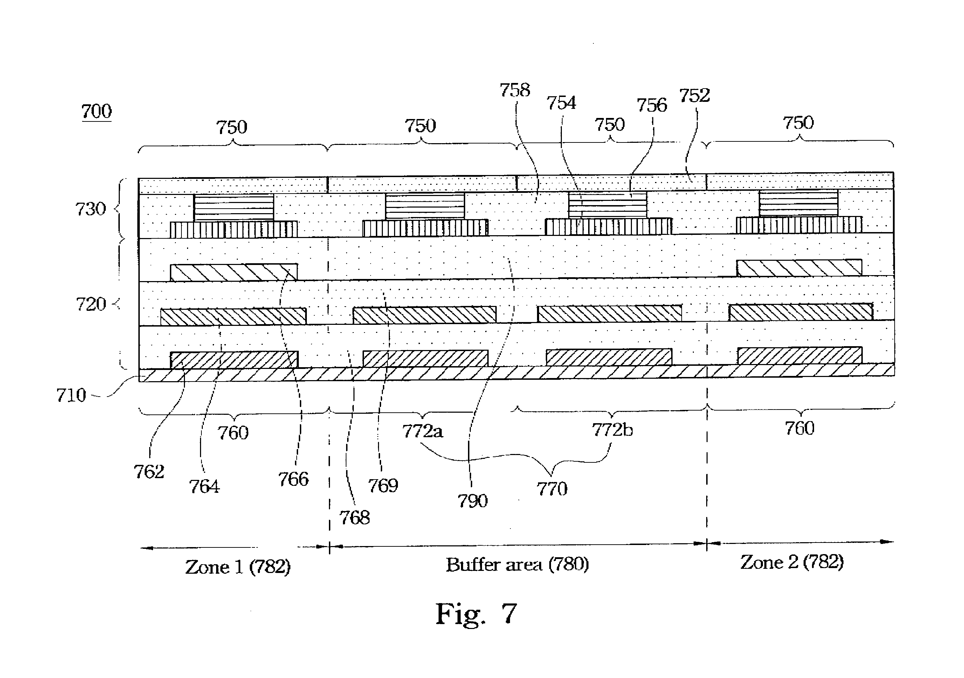

Fig. 7 shows a partial cross sectional view of a top emission type AMOLED display device 700 according to one embodiment of the present invention. The AMOLED display device 700 includes a circuit layer 720 formed on a substrate 710 such as glass, and an emission layer 730 formed on the circuit layer 720. The emission layer 730 includes a plurality of regularly spaced emission pixels 750. Each emission pixel 750 has a cathode 752, an anode 754, and an organic active layer 756 disposed between the cathode 752 and the anode 754. Neighboring emission pixels 750 are separated by a pixel define material 758. The circuit layer 720 includes a plurality of pixel circuits 760. Each pixel circuit 760 comprises a TFT. The TFT comprises a semiconductor layer 762, a gate electrode 764, a source/drain electrode 766, a dielectric layer 769 disposed between the gate electrode 764 and the source/drain electrode 766, and a gate insulator layer 768 disposed between the semiconductor layer 762 and the gate electrode 764. A flatten layer 790 is disposed between the circuit layer 720 and the emission layer 730. The plurality of pixel circuits 760 are arranged in a plurality of zones 782. A buffer circuit 770 is positioned in a space 780 between two neighboring zones 782. The buffer circuit 770 comprises two logic inverters 772a and 772b. In another embodiment, the bottom emission type OLED, the circuit layer disposed on the above side of the emission layer, so those skill in the art will disposed the circuit layer on the non-emission side of the emission layer for prevent blocking light transmitting.

In summary, by using multiple buffer circuits to drive each row of pixels and positioning the buffer circuits in the display area, an AMOLED display device can be made with a relatively slim border. For example, the display area of a 3.7" wide video graphic array (WVGA) with a resolution of 480×800 may be divided into 12 vertical zones. Each zone includes 40 columns of pixels. The panel loading for 480 pixels in each row has an equivalent RC value of about 9 kΩ and 80 pF, respectively. In comparison, the panel loading for 40 pixels has an equivalent RC value of about 2 kΩ and 12 pF, respectively. A buffer circuit configured to drive 40 pixels can be positioned in a buffer area between neighboring zones having a width of about 22 µm. Consequently, the width of the panel border can be reduced from 1950 µm in a conventional AMOLED display device to about 1570 µm according one embodiment of the present invention.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to activate others skilled in the art to utilize the invention and various embodiments and with various modifications as are suited to the particular use contemplated. Alternative embodiments will become apparent to those skilled in the art to which the present invention pertains without departing from its spirit and scope. Accordingly, the scope of the present invention is defined by the appended claims rather than the foregoing description and the exemplary embodiments described therein.

## Claims

1. An active matrix electroluminescent display device, comprising:
(a) an emission layer comprising a plurality of regularly-spaced emission pixels disposed in a row; and
(b) a circuit layer disposed under the emission layer, the circuit layer comprising:
a plurality of pixel circuits, each pixel circuit electrically coupled to a respective emission pixel for controlling current through the respective emission pixel in response to an applied data signal, wherein the plurality of pixel circuits is spatially arranged into a plurality of groups with each group including one or more adjacent pixel circuits, wherein any two neighboring groups of adjacent pixel circuits are separated by a space therebetween; and
a plurality of buffer circuits connected to each other in series, each buffer circuit configured to drive a respective group of adjacent pixel circuits in response to a scan signal, wherein at least one buffer circuit is positioned in a respective space between two neighboring groups of adjacent pixel circuits.

2. The display device of claim i, wherein the number of pixel circuits in each group is the same for all groups.

3. The display device of claim 1, wherein each buffer circuit comprises one or more logic inverters.

4. The display device of claim 3, wherein each logic inverter comprises a thin film transistor (TFT) having a channel width along the row direction.

5. The display device of claim 4, wherein the one or more logic inverters in each buffer circuit comprises two ore more logic inverters connected to each other in series, wherein a TFT of any one but the first logic inverter has a channel width that is greater than a channel width of a TFT of a previous logic inverter.

6. An active matrix electroluminescent display device, comprising:
(a) an emission layer comprising a plurality of regularly-spaced emission pixels positioned in a display area in a form of a matrix with a plurality of rows and a plurality of columns; and
(b) a circuit layer disposed on a non-emission side of the emission layer, the circuit layer comprising:
a plurality of pixel circuits, each pixel circuit electrically coupled to a respective emission pixel for controlling current through the respective emission pixel in response to an applied data signal, wherein the plurality of pixel circuits is spatially arranged in a plurality of zones, each zone including one or more columns of pixel circuits and having an area with a width in the row direction that is narrower than a width of an area occupied by corresponding one or more columns of emission pixels in the emission layer such that any two neighboring zones are separated by a space therebetween; and
a plurality of buffer circuitries, each buffer circuitry electrically coupled to a respective row of pixel circuits and comprising a plurality of buffer circuits connected to each other in series, each buffer circuit configured to drive one or more adjacent pixel circuits in a respective zone in the respective row in response to a scan signal, at least one buffer circuit being positioned in a respective space between two neighboring zones.

7. The display device of claim 6, further comprising a shift register, the shift register comprising a plurality of stages, each stage configured to output a scan signal to a respective buffer circuitry in response to a clock signal, wherein the plurality of stages of the shift register is connected to each other in series so that successive rows of pixel circuits are sequentially driven in a row-by-row fashion.

8. The display device of claim 7, wherein the shift register is disposed at a peripheral edge of the display area in the column direction.

9. The display device of claim 7, wherein the plurality of stages of the shift register is disposed at two opposite peripheral edges of the display area in the column direction.

10. The display device of claim 7, wherein each stage of the shift register comprises a complementary metal oxide semiconductor (CMOS) transistor, wherein the CMOS transistor is a TFT.

11. The display device of claim 6, wherein each buffer circuit in each buffer circuitry comprises at least one TFT having a channel width along the row direction.

12. A method of driving an active matrix electroluminescent display device, the display device comprising an emission layer and a circuit layer, the emission layer including a plurality of regularly-spaced emission pixels disposed in a display area in a form of a matrix with a plurality of rows and a plurality of columns, the circuit layer being disposed under the emission layer and including a plurality of pixel circuits, each pixel circuit electrically coupled to a respective emission pixel for controlling the current through the respective emission pixel in response to an applied data signal, wherein the plurality of pixel circuits in each row is arranged into a plurality of groups with each group including one or more adjacent pixel circuits, the method comprising the step of:
providing a clock signal to a shift register, the shift register comprising a plurality of stages, each stage corresponding to a respective row of pixel circuits and configured to output a scan signal to a respective buffer circuitry in response to the clock signal, the respective buffer circuitry comprising a plurality of buffer circuits connected to each other in series, each buffer circuit configured to drive a respective group of adjacent pixel circuits in the respective row, wherein the plurality of stages of the shift register is connected to each other in series such that successive rows of pixel circuits are sequentially driven in a row-by-row fashion.

13. The method of claim 13, wherein at least one buffer circuit in each buffer circuitry is disposed in a space between two neighboring groups of adjacent pixel circuits in the respective row.

14. The method of claim 13, wherein the shift register is disposed at a peripheral edge of the display area in the column direction.

15. The method of claim 13, wherein the plurality of stages of the shift register is disposed at two opposite peripheral edges of the display area in the column direction.
